Europäisches Patentamt

European Patent Office

Office européen des brevets

(19)

(11) Veröffentlichungsnummer: **0 286 852 B1**

(12)                    **EUROPÄISCHE PATENTSCHRIFT**

(45) Veröffentlichungstag der Patentschrift: **29.05.91**

(51) Int. Cl.⁵: **G11C 29/00**

(21) Anmeldenummer: **88104116.4**

(22) Anmeldetag: **15.03.88**

(54) **Schaltungsanordnung und Verfahren zum Testen von Speicherzellen.**

(30) Priorität: **16.03.87 DE 3708489**

(43) Veröffentlichungstag der Anmeldung:
**19.10.88 Patentblatt 88/42**

(45) Bekanntmachung des Hinweises auf die
Patenterteilung:
**29.05.91 Patentblatt 91/22**

(84) Benannte Vertragsstaaten:
**AT DE FR GB IT NL**

(56) Entgegenhaltungen:
**EP-A- 0 143 624**
**DE-A- 3 530 591**

**PATENT ABSTRACTS OF JAPAN, Band 6, Nr. 188 (P-144)[1066], 28. September 1982; & JP-A-57 100 690 (TOKYO SHIBAURA DENKI K.K.) 22-06-1982**

**PROCEEDINGS OF THE 1986 INTERNATIO-NAL TEST CONFERENCE, Philadelphia, 8.-11. September 1986, Seiten 830-839, IEEE; K.T. LE et al.: "A novel approach for testing me-mories using a built-in self testing techni-que"**

(73) Patentinhaber: **Siemens Aktiengesellschaft**
**Wittelsbacherplatz 2**
**W-8000 München 2(DE)**

(72) Erfinder: **Hoffmann, Kurt, Dr. Prof.**
**Nelkenweg 20**
**W-8028 Taufkirchen(DE)**
Erfinder: **Kowarik, Oskar, Dr. rer. nat.**
**Goethering 70**
**W-8018 Grafing(DE)**
Erfinder: **Kraus, Rainer, Dipl.-Phys.**
**Weidener Strasse 21**
**W-8000 München 83(DE)**
Erfinder: **Paul, Manfred, Dipl.-Ing.**
**Fichtenstrasse 18**
**W-8043 Unterföhring(DE)**

EP 0 286 852 B1

**Beschreibung**

Die Erfindung betrifft eine Schaltungsanordnung zum Testen von Speicherzellen nach dem Oberbegriff des Patentanspruches 1 sowie ein Verfahren zum Testen von Speicherzellen nach dem Oberbegriff des Patentanspruches 7.

Die Zunahme der Anzahl von Speicherzellen in einem Halbleiterspeicher hat in den letzten Jahren zu einem enormen Anstieg der zum Testen eines Halbleiterspeichers notwendigen Testzeit geführt. Während beispielsweise ein DRAM mit 4kB Speicherkapazität seinerzeit in drei bis 20 Sekunden Prüfzeit (abhängig von Art und Anzahl der verwendeten Prüfmuster und sonstiger Prüfbedingungen) ausreichend prüfbar war, bewegt sich die Prüfzeit eines modernen 1MB-DRAM's in der Größenordnung von 20 Minuten.

Es sind bereits verschiedene Maßnahmen zur Verkürzung der Prüfzeit bekannt: Die EP-A 0186040 schlägt beispielsweise vor, einen Halbleiterspeicher intern in mehrere gleiche Blöcke einzuteilen und diese parallel zueinander zu testen. Damit läßt sich in der Praxis die Testzeit auf etwa 1/4 bis 1/8 reduzieren.

Die US-PS 4,055,754 schlägt vor, jeweils alle Speicherzellen einer kompletten Wortleitung zeitlich parallel zueinander zu testen und dazu eine bestimmte Auswerteschaltung innerhalb des Halbleiterspeichers zu benützen. Diese Lösung ist, trotz großer Testzeitersparnis, insofern nachteilig, als eine Auswerteschaltung notwendig ist, die aus wenigstens drei logischen Gattern besteht, wovon zwei dieser Gatter eine Anzahl von Eingängen benötigen, die gleich der Anzahl der vorhandenen Wortleitungen ist. Eine Realisierung führt zu einem sehr großen zusätzlichen Flächenbedarf, was dem allgemeinen Drang hin zum Miniaturisieren von Schaltungen zuwiderläuft.

Aufgabe der vorliegenden Erfindung ist es deshalb, eine gattungsgemäße Schaltungsanordnung zu schaffen, die das Testen von Speicherzellen bei kurzem Zeitaufwand und minimalem zusätzlichen Flächenbedarf ermöglicht. Es ist weiterhin Aufgabe der vorliegenden Erfindung, ein entsprechendes Verfahren zum Testen von Speicherzellen anzugeben

Diese Aufgabe wird gelöst durch die kennzeichnenden Merkmale der Patentansprüche 1 und 7. Vorteilhafte Aus- und Weiterbildungen sind in Unteransprüchen gekennzeichnet.

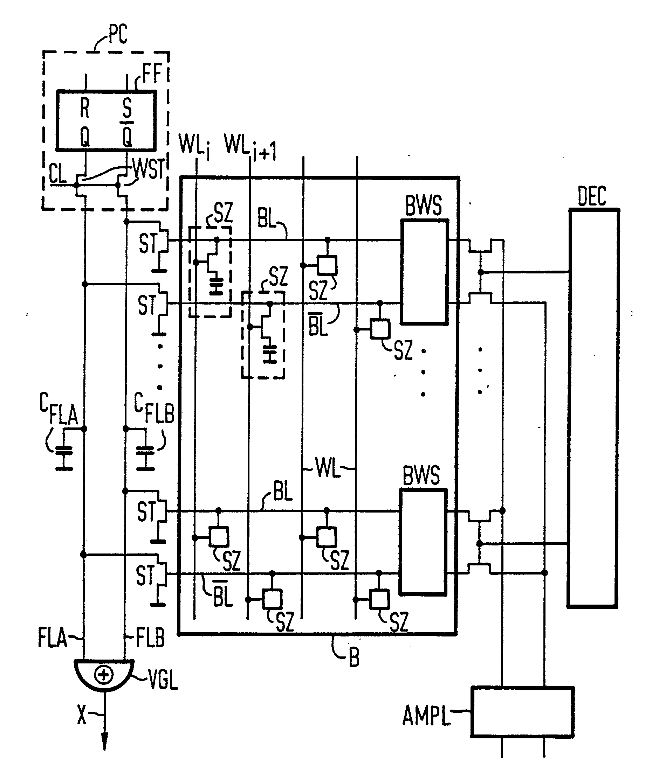

Die Erfindung wird anhand der Figur näher erläutert.

Die Figur zeigt einen Block B mit Speicherzellen SZ. Der zugehörige Halbleiterspeicher kann einen oder mehrere Blöcke B aufweisen. Dies ist Stand der Technik und aus Gründen der Übersichtlichkeit nicht dargestellt. Die Speicherzellen SZ sind matrixförmig angeordnet. Sie sind über Wortleitungen WLi, WLi+1, allgemein WL, und über Bitleitungen adressierbar. Jeder Bitleitung ist, wie allgemein bekannt, eine Bewerterschaltung BWS zugeordnet.

Diese teilt die Bitleitung in zwei wenigstens annähernd gleiche Bitleitungshälften BL, $\overline{BL}$. Im allgemeinen sind die beiden Hälften aus Symmetriegründen im Hinblick auf die Funktionsweise der Bewerterschaltung BWS exakt gleich, soweit technologisch möglich.

Hinsichtlich der Anordnung von Bitleitungen und Bewerterschaltungen BWS sind dem Fachmann zwei verschiedene Konzepte bekannt. Beim älteren, sogenannten "Open-Bitline-Konzept" sind die beiden Bitleitungshälften beidseitig zu Bewerterschaltungen BWS angeordnet. Die Bewerterschaltungen BUS teilen also das Speicherzellenfeld eines Blockes B in eine linke und eine rechte Zellenfeldhälfte. Beim moderneren Bitleitungskonzept, "Folded-Bitline-Konzept" genannt, sind beide Bitleitungshälften auf einer einzigen Seite der Bewerterschaltung BWS angeordnet. Die Bewerterschaltungen BWS sind bei diesem Konzept also am Rande des Zellenfeldes zu finden. Die vorliegende Erfindung ist bei beiden Bitleitungskonzepten realisierbar.

Auch die Bewerterschaltungen und die Speicherzellen sind Stand der Technik. Der Fachwelt bekannte Bewerterschaltungen enthalten zwei über ihre Gates kreuzgekoppelte Transistoren mit einem gemeinsamen Anschluß an ein meist schaltbares oder in seinem zeitlichen Verlauf steuerbares Potential. Die freien Enden der Transistoren der Bewerterschaltungen sind jeweils mit einer Bitleitungshälfte BL, $\overline{BL}$ verbunden. Andere Ausgestaltungen nach dem Stande der Technik sind denkbar.

Auch die Speicherzellen sind nach dem Stand der Technik gestaltet. Bei einem DRAM als Halbleiterspeicher sind es im allgemeinen 1-Transistorspeicherzellen. Auf statische Speicher (SRAM's) und auf programmierbare Speicher wie EPROM's und EEPROM's ist die vorliegende Erfindung ebenfalls ohne wesentliche Änderungen anwendbar. Im vorliegenden Fall sind 1-Transistorspeicherzellen eines DRAM's dargestellt. Ob die Speicherkonzeption so angelegt ist, daß sogenannte Dummyzellen vorzusehen sind, oder ob die Bewerterschaltung nach dem sogenannten Mid-Level-Konzept arbeitet, ist für die Anwendung der Erfindung ebenfalls ohne Belang.

Die erfindungsgemäße Schaltungsanordnung enthält weiterhin je Block B ein Paar von Fehlerleitungen FLA,FLB. Diese sind beispeilsweise an ihrem einen Ende (jede beliebige andere Position ist auch denkbar) mit einer Vorladeeinrichtung PC verbunden. Sie dient dem Vorladen der Fehlerleitungen FLA,FLB samt parasitärer Kapazitäten $C_{FLA}$,

$C_{FLB}$ auf zueinander komplementäre logische Pegel, was noch beschrieben wird. Das Paar von Fehlerleitungen FLA,FLB bildet Eingänge einer Vergleicherschaltung VGL. Der Ausgang der Vergleicherschaltung VGL dient der Anzeige eines aufgetretenen Fehlers im Testfall.

Bei jeder Bitleitung ist jeder ihrer Bitleitungshälften BL,$\overline{BL}$ ein Schalttransistor ST zugeordnet. Das Gate jedes Schalttransistors ST ist mit der ihm zugeordneten Bitleitungshälfte BL,$\overline{BL}$ verbunden. Die Sources aller Schalttransistoren ST sind gemeinsam mit einem Potential verbunden, das wertemäßig einem der beiden zuvor genannten logischen Pegel entspricht. Diese beiden logischen Pegel sind von der Bedeutung her gleich den logischen Pegeln, die im (Test-)Betrieb als Information in den Speicherzellen gespeichert sind und potentialmäßig im wesentlichen gleich den Pegeln, die beim Auslesen der Information aus den Speicherzellen durch Bewerten und Verstärken mittels der Bewerterschaltungen entstehen und meist gleich den Versorgungsspannungen VDD und VSS sind.

Bei jeder Bitleitung ist einerseits die Drain desjenigen Schalt transistors ST, der gatemäßig mit der ersten Bitleitungshälfte BL verbunden ist, mit der zweiten Fehlerleitung FLB verbunden und andererseits ist die Drain desjenigen Schalttransistors ST, der gatemäßig mit der zweiten Bitleitungshälfte $\overline{BL}$ verbunden ist, mit der ersten Fehlerleitung FLA verbunden.

In vorteilhafter Weiterbildung der Erfindung ist das Potential, mit dem die Source jedes Schalttransistors ST verbunden ist, gleich dem allgemeinen Bezugspotential der gesamten Schaltungsanordnung, meist als Masse bezeichnet. In einer weiteren vorteilhaften Weiterbildung der Erfindung ist das Potential, mit dem die Source jedes Schalttransistors ST verbunden ist, gleich dem der allgemeinen Versorgungsspannung der gesamten Schaltungsanordnung, oft mit dem Symbol VDD bezeichnet.

In einer Ausführungsform der Erfindung weist die Vorladeeinrichtung PC eine RS-Flipflop-Schaltung FF auf mit zwei üblichen, zueinander komplementären Ausgängen Q,$\overline{Q}$. Jeder Ausgang Q,$\overline{Q}$ ist über einen weiteren Schalttransistor WST mit dem Paar von Fehlerleitungen FLA,FLB verbunden. Die Gates der weiteren Schalttransistoren WST sind mit einem Clocksignal CL verbunden. Dieses steuert im Testfall das Vorladen der Fehlerleitungen FLA,FLB durch die Vorladeeinrichtung PC.

Es ist vorteilhaft, daß die Vergleicherschaltung VGL in einer ersten Ausführungsform eine XOR-Schaltung ist.

Es ist weiterhin vorteilhaft, daß die Vergleicherschaltung in einer zweiten Ausführungsform eine XNOR-Schaltung ist.

Der Vollständigkeit halber ist noch erwähnt, daß der Block B von Speicherzellen SZ, wie allgemein üblich, über Spalten- und Zeilendekoder angesteuert wird, daß weiterhin ein externer (weiterer) Verstärker vorgesehen ist, der auch dem Vorladen der Bitleitungen dienen kann, und daß auch sonst üblicherweise vorhandene Schaltungen wie z.B. Adreß- und Datenpuffer vorhanden sind. Diese Schaltungen betreffen jedoch nicht die erfindungsgemäße Ausgestaltung der Schaltungsanordnung. Die Figur zeigt deshalb und auch aus Gründen der Übersichtlichkeit nur einen externen Verstärker AMPL und die Bitleitungsdekoder DEC.

Anhand der geschilderten vorteilhaften Schaltungsanordnung läßt sich nun das erfindungsgemäße Verfahren schildern:

Im Testfall werden je Wortleitung WL alle mit dieser Wortleitung WL verbundenen Speicherzellen SZ auf einen logischen Pegel aufgeladen, der für alle mit der Wortleitung WL verbundenen Speicherzellen SZ gleich ist. Der logische Pegel steht stellvertretend für eine in die Speicherzellen SZ einzuschreibende Information. Der logische Pegel kann durchaus unterschiedlich sein (log. 0 oder log. 1) bei den einzelnen Wortleitungen. Es ist nur wichtig, daß innerhalb einer Wortleitung alle Speicherzellen mit der gleichen Information beschrieben werden.

Damit ist die Auswahl der möglichen anzuwendenden Prüfmuster auf solche Prüfmuster beschränkt, bei denen alle Speicherzellen einer Wortleitung die gleiche Information enthalten. Solche Prüfmuster sind z.B. "All 0's", "All 1's", "Alternating Columns", linke Hälfte des Speicherzellenfeldes "All 0's" und rechte Hälfte "All 1's" oder umgekehrt. Nicht möglich ist beispielsweise das Prüfmuster "Checkerboard", bei dem bekanntlich die in den Speicherzellen einer Wortleitung gespeicherte Information von Speicherzelle zu Speicherzelle alterniert ('1010'). Für einfache Funktionstests wie Incoming Inspection oder Grobprüfung daraufhin, ob der Speicher überhaupt funktionsfähig ist, ist dies jedoch völlig ausreichend. Wenn man die Speicherzellen jeder Wortleitung sowohl auf "Information gleich log. 0" als auch auf "Information gleich log. 1" prüft, lassen sich mit dem erfindungsgemäßen Verfahren folgende Fehler in jedem Fall finden:

a) Bitleitung ist auf ein (beliebiges) Potential "festgeklemmt";

b) (wenigstens) eine Speicherzelle ist auf ein (beliebiges) Potential "festgeklemmt".

Die nachfolgenden Fehlertypen lassen sich in den meisten Fällen feststellen:

a) (Wenigstens) ein Bitleitungsdekoder und/oder Wortleitungsdekoder arbeitet fehlerhaft;

b) (wenigstens) eine Wortleitung ist auf ein (beliebiges) Potential festgeklemmt;

c) (wenigstens) eine Bewerterschaltung arbeitet fehlerhaft.

Die notwendige Testzeit ist nicht, wie üblich, bestimmt unter anderem durch die Anzahl der (zu prüfenden) Speicherzellen SZ, sondern durch die Anzahl der Wortleitungen WL.

Entweder gleichzeitig mit dem Beschreiben der Speicherzellen SZ oder anschließend daran, jedoch vor dem Auslesen aus den Speicherzellen SZ einer Wortleitung, wird das Paar von Fehlerleitungen FLA,FLB auf zwei zueinander komplementäre logische Pegel aufgeladen (log. 0, log. 1). Diese logischen Pegel sind von ihrer Bedeutung her gleich den logischen Pegeln, die in die Speicherzellen als Informationen einschreibbar sind. Die Zuordnung der logischen Pegel zu den beiden Leitungen des Paares von Fehlerleitungen FLA,FLB wird beispielsweise so getroffen, allgemein ausgedrückt, daß für diejenige der Fehlerleitungen FLA,FLB, die über mit ihr verbundene Schaltmittel mit einer solchen Bitleitungshälfte BL,$\overline{BL}$verbunden ist, deren zugehörige Speicherzellen zu testen sind, der logische Pegel komplementär ist zu dem logischen Pegel, den diese Speicherzellen SZ als Information in Form gespeicherter Ladungen aufweisen.

Im konkreten Fall, auf die erfindungsgemäße Schaltungsanordnung der Figur bezogen, bedeutet dies: Es sei angenommen, daß (im nächsten Testzyklus) alle die mit der Wortleitung WLi verbundenen Speicherzellen SZ getestet werden sollen. In diesen Speicherzellen SZ sei eine logische 1 als Information in Form von elektrischen Ladungen gespeichert. Diese Speicherzellen SZ sind alle mit den ersten Bitleitungshälften BL ihrer ihnen zugeordneten Bitleitungen verbunden. Jede dieser ersten Bitleitungshälften BL der Bitleitungen steuert das Gate eines Schalttransistors ST an. Die Schalttransistoren ST wirken allgemein als Schaltmittel. Über die Schalttransistoren ST besteht eine steuernde Verbindung zu der Fehlerleitung FLB, wie bereits beschrieben. Die zweite Bitleitungshälfte $\overline{BL}$ist über als Schaltmittel wirkende Schalttransistoren ST mit der ersten Fehlerleitung FLA verbunden. Da nun die zu testenden Speicherzellen SZ angenommenermaßen eine logische 1 gespeichert haben sollen, ist die Fehlerleitung FLB auf eine logische 0 vorzuladen. Entsprechend ist die erste Fehlerleitung FLA komplementär dazu auf eine logische 1 vorzuladen. Im vorliegenden Beispiel wurde angenommen, daß die Schaltmittel, d.h. in der Realisierung nach der Figur die Schalttransistoren ST, einseitig (beispielsweise mit ihrer Source) mit dem allgemeinen Bezugspotential Masse der gesamten Schaltungsanordnung verbunden sind.

Das Vorladen selbst erfolgt durch die Vorladeeinrichtung PC. In dem Falle, in dem die Vorladeeinrichtung PC ein RS-Flipflop FF aufweist, wird dieses beispielsweise so gesetzt, daß sein der Fehlerleitung FLA zugeordneter Ausgang Q eine logische 1 aufweist und sein der Fehlerleitung FLB zugeordneter Ausgang $\overline{Q}$eine logische 0 aufweist. Der Vorladevorgang selbst wird bei dieser Ausführungsform mittels der weiteren Schalttransistoren WST durchgeführt. Dazu werden, wie bereits erwähnt, während oder nach dem Einschreiben der Informationen in die Speicherzellen SZ, über ein Clocksignal CL gesteuert, die weiteren Schalttransistoren WST leitend geschaltet und wieder gesperrt.

Daraufhin wird, gesteuert durch in der Figur nicht dargestellte Wortleitungsdekoder, die nach dem Stand der Technik sein können, genau eine Wortleitung, im Beispiel die Wortleitung WLi aktiviert. Somit gelangt bei allen mit dieser Wortleitung WLi verbundenen Speicherzellen SZ die gespeicherte Information auf die der jeweiligen Speicherzelle zugeordnete Bitleitungshälfte, im Beispiel speziell auf die erste Bitleitungshälfte BL. Nun werden auf bekannte Art und Weise die elektrischen Zustände jeder Bitleitung durch die ihr zugeordnete Bewerterschaltung BWS bewertet und verstärkt. Dadurch bilden sich auf den beiden Bitleitungshälften BL,$\overline{BL}$jeder Bitleitung die logischen Zustände 0 und 1 mit elektrisch deutlich voneinander unterscheidbaren Pegeln aus.

Im vorliegenden Beispiel wurde angenommen, daß eine logische 1 aus den Speicherzellen SZ auszulesen sei. Sind nun alle ausgelesenen Speicherzellen SZ in Ordnung, so ist auf jeder ersten Bitleitungshälfte BL eine logische 1 und auf jeder zweiten Bitleitungshälfte $\overline{BL}$eine logische 0. Damit sind sämtliche Schalttransistoren, die jeweils mit der ersten Hälfte BL der Bitleitungen verbunden sind, durchgeschaltet. In der Figur ist die Source jeweils mit Masse verbunden. Diese entspricht der logischen 0. Diese wird über jeden der durchgeschalteten Schalttransistoren ST auf die Fehlerleitung FLB gegeben; am einen Eingang der Vergleicherschaltung VGL liegt eine logische 0.

Diejenigen Schalttransistoren ST jedoch, die jeweils mit der zweiten Bitleitungshälfte $\overline{BL}$einer Bitleitung verbunden sind, sind alle gesperrt, weil allen zweiten Bitleitungshälften $\overline{BL}$der Bitleitungen durch die Bewerterschaltungen eine eindeutige logische 0 eingeprägt ist. Damit bleibt die auf der Fehlerleitung FLA durch das Vorladen eingeprägte logische 1 erhalten. Sie dient als Eingangssignal am anderen Eingang der Vergleicherschaltung VGL. Die Vergleicherschaltung VGL erkennt somit, daß an ihren Eingängen verschiedene Signale anliegen, was "gut" bedeutet. Entsprechendes zeigt ihr Ausgangssignal X an.

Falls jedoch wenigstens ein Fehler auftritt, so weisen die beiden Bitleitungshälften BL,BL der vom Fehler betroffenen Bitleitung logische Zustände auf, die von den zuvor beschriebenen logischen Zuständen abweichen. Das heißt also, bei mindestens einer Bitleitung wird der der ersten Bitleitungshälfte BL zugeordnete Schalttransistor gesperrt und entsprechend der der zweiten Bitleitungshälfte $\overline{BL}$ zugeordnete Schalttransistor wird leitend. Somit behält zwar die Fehlerleitung FLB ihren (vorgeladenen) Zustand logisch 0 bei, die Fehlerleitung FLA jedoch wird auf logisch 0 geschaltet. Die Vergleicherschaltung VGL erhält an ihren Eingängen gleiche Eingangssignale, was sie als Fehler auswertet und entsprechend als Fehlersignal ihr Ausgangssignal X setzt.

In der bereits beschriebenen Ausführungsform, in der die Sources der Schalttransistoren ST mit der allgemeinen Versorgungsspannung VDD verbunden sind, ist das Par von Fehlerleitungen FLA,FLB bei gleichem Speicherinhalt der zu testenden Speicherzellen SZ entgegengesetzt zum bisher geschilderten Fall aufzuladen. Der weitere Ablauf ist analog dem zuvor beschriebenen.

Es ist vorteilhaft, die Auswertung durch die Vergleicherschaltung mittels einer XOR- oder einer XNOR-Schaltung durchzuführen.

Der Fall, daß aus den Speicherzellen SZ einer Wortleitung WL als auszulesende Information eine logische 0 im "Gut-"Fall zu erwarten ist, ist anhand des oben Gesagten vom Fachmann leicht nachvollziehbar. Von einer näheren Erläuterung wird deshalb abgesehen.

Hinsichtlich der Erzeugung von speziellen Test- und Steuersignalen wird insbesondere auf die im Zeitrang gleiche EP-A-0282976 hingewiesen. Bezüglich spezieller Dekoderausgestaltungen wird auf die im Zeitrang gleiche EP-A-0282975 und EP-A-0283908 hingewiesen.

## Ansprüche

1. Schaltungsanordnung zum Prüfen von matrixförmig angeordneten Speicherzellen, die über Wort- und Bitleitungen ansteuerbar sind, bei der jeder Bitleitung eine Bewerterschaltung zugeordnet ist, die die Bitleitung in zwei gleiche Bitleitungshälften teilt, **gekennzeichnet durch** folgende weitere Merkmale:
   - Ein Paar von Fehlerleitungen (FLA,FLB) ist mit einer Vorladeeinrichtung (PC) verbunden,
   - das Paar von Fehlerleitungen (FLA,FLB) bildet Eingänge einer Vergleicherschaltung (VGL),
   - ein Ausgangssignal (X) der Vergleicherschaltung (VGL) zeigt im Testbetrieb das Auftreten von Fehlern an,
   - bei jeder Bitleitung ist jede ihrer Bitleitungshälften (BL, $\overline{BL}$) mit dem Gate eines Schalttransistors (ST) verbunden,
   - die Source jedes der Schalttransistoren (ST) ist mit einem Potential verbunden, das einem von zwei zueinander komplementären logischen Pegeln entspricht, die das Paar von Fehlerleitungen (FLA,FLB) im Testbetrieb annimmt,
   - für jede Bitleitung ist einerseits die Drain desjenigen Schalttransistors (ST), der gatemäßig mit der zweiten Bitleitungshälfte ($\overline{BL}$) verbunden ist, mit der ersten Fehlerleitung (FLA) des Paares von Fehlerleitungen (FLA,FLB) verbunden und andererseits ist die Drain desjenigen Schalttransistors (ST), der gatemäßig mit der ersten Bitleitungshälfte (BL) verbunden ist, mit der zweiten Fehlerleitung (FLB) des Paares von Fehlerleitungen (FLA,FLB) verbunden.

2. Schaltungsanordnung nach Anspruch 1, **dadurch gekennzeichnet**, daß das Potential, mit dem die Source jedes Schalttransistors (ST) verbunden ist, gleich dem Bezugspotential (Masse) der gesamten Schaltungsanordnung ist.

3. Schaltungsanordnung nach Anspruch 1, **dadurch gekennzeichnet**, daß das Potential, mit dem die Source jedes Schalttransistors (ST) verbunden ist, gleich dem Versorgungspotential (VDD) der gesamten Schaltungsanordnung ist.

4. Schaltungsanordnung nach einem der vorhergehenden Ansprüche, **dadurch gekennzeichnet**, daß die Vorladeeinrichtung (PC) eine RS-Flipflop-Schaltung (FF) aufweist mit zwei zueinander komplementären Ausgängen (Q,$\overline{Q}$) und daß die Ausgänge (Q,$\overline{Q}$) über weitere Schalttransistoren (WST) mit dem Paar von Fehlerleitungen (FLA,FLB) verbunden sind.

5. Schaltungsanordnung nach einem der vorhergehenden Ansprüche, **dadurch gekennzeichnet**, daß die Vergleicherschaltung (VGL) eine XOR-Schaltung ist.

6. Schaltungsanordnung nach einem der Ansprüche 1 bis 4, **dadurch gekennzeichnet**, daß die Vergleicherschaltung (VGL) eine XNOR-Schaltung ist.

7. Verfahren zum Testen von Speicherzellen, die matrixförmig angeordnet sind, die über Wortleitungen und Bitleitungen ansteuerbar sind, deren Bitleitungen jeweils über eine Bewerterschaltung in zwei gleiche Hälften aufgeteilt ist, **gekennzeichnet durch** folgende Merkmale:
   - Im Testfall werden alle mit einer Wortleitung (WL) verbundenen Speicherzellen (SZ) auf einen gleichen logischen Pegel aufgeladen,

- ein Paar von Fehlerleitungen (FLA,FLB) wird auf zwei zueinander komplementäre logische Pegel aufgeladen, die in ihrer Bedeutung gleich sind denjenigen logischen Pegeln, die in die Speicherzellen (SZ) in Form von elektrischen Ladungen einschreibbar sind,

- eine Wortleitung (WL) wird aktiviert, so daß die in den mit ihr verbundenen Speicherzellen gespeicherte Ladung auf die jeweils zugehörigen Bitleitungshälften (BL,$\overline{BL}$) gelangt,

- die Bewerterschaltungen (BWS) bewerten und verstärken die so ausgelesenen Ladungen und bilden so die den ausgelesenen Ladungen zugehörigen logischen Pegel,

- die logischen Pegel steuern Schaltmittel (ST) an, die entsprechend ihrer Ansteuerung durchschalten oder sperren,

- je nach Schaltverhalten der Schaltmittel behalten die beiden Fehlerleitungen (FLA,FLB) ihren logischen Zustand bei oder eine der Fehlerleitungen (FLA;FLB) ändert ihn,

- über eine Vergleicherschaltung (VGL) wird überprüft, ob die Fehlerleitungen nach dem Auslesen und Bewerten der Ladungen der Speicherzellen (SZ) noch die durch das Vorladen eingeprägten zueinander komplementären logischen Pegel aufweisen.

8. Verfahren nach Anspruch 7, **dadurch gekennzeichnet**, daß das Vorladen unter Verwendung eines RS-Flipflops (FF) erfolgt und daß die Ausgänge (Q,$\overline{Q}$) des RS-Flipflops (FF) nach dem Vorladen durch weitere Schaltmittel (WST) von den Fehlerleitungen (FLA,FLB) abgeschaltet werden.

9. Verfahren nach Anspruch 7 oder Anspruch 8, **dadurch gekennzeichnet**, daß die Auswertung durch die Vergleicherschaltung (VGL) mittels einer XOR-Schaltung durchgeführt wird.

10. Verfahren nach Anspruch 7 oder Anspruch 8, **dadurch gekennzeichnet**, daß die Auswertung durch die Vergleicherschaltung (VGL) mittels einer XNOR-Schaltung durchgeführt wird.

11. Verfahren nach einem der Ansprüche 7 bis 10, **dadurch gekennzeichnet**, daß die Zuordnung der logischen Pegel zu den beiden Leitungen des Paares von Fehlerleitungen (FLA,FLB) so getroffen wird, daß für diejenige Fehlerleitung (FLA;FLB), die über mit ihr verbundene Schaltmittel (ST) mit den in einem Testzyklus zu testenden Speicherzellen (SZ) verbunden ist, der logische Pegel komplementär ist zu dem logischen Pegel, den die zu testenden Speicherzellen (SZ) in Form gespeicherter Ladung im 'Gut'-Fall aufweisen.

12. Verfahren nach einem der Ansprüche 7 bis 10, **dadurch gekennzeichnet**, daß die Zuordnung der logischen Pegel zu den beiden Leitungen des Paares von Fehlerleitungen (FLA,FLB) so getroffen wird, daß für diejenige Fehlerleitung (FLA;FLB), die über mit ihr verbundene Schaltmittel (ST) mit den in einem Testfall zu testenden Speicherzellen (SZ) verbunden ist, der logische Pegel gleich ist zu dem logischen Pegel, den die zu testenden Speicherzellen (SZ) in Form gespeicherter Ladung im 'Gut'-Fall aufweisen.

## Claims

1. Circuit arrangement for testing memory cells which are arranged in a matrix and can be driven via word and bit lines, in which there is assigned to each bit line an evaluator circuit which devides the bit line into two identical bit line halves, characterised by the following features:

- a pair of fault lines (FLA, FLB) is connected to a precharging device (PC),

- the pair of fault lines (FLA, FLB) forms inputs of a comparator circuit (VGL),

- an output signal (X) of the comparator circuit (VGL) indicates the occurrence of faults in test operation,

- in each bit line, each of its bit line halves (BL, $\overline{BL}$) is connected to the gate of a switching transistor (ST),

- the source of each of the switching transistors (ST) is connected to a potential that corresponds to two mutually complementary logic levels which the pair of fault lines (FLA, FLB) assumes in test operation,

- for each bit line, on the one hand the drain of the switching transistor (ST) whose gate is connected to the second bit line half ($\overline{BL}$) is connected to the first fault line (FLA) of the pair of fault lines (FLA, FLB), and on the other hand the drain of the switching transistor (ST) whose gate is connected to the first bit line half (BL) is connected to the second fault line (FLB) of the pair of fault lines (FLA, FLB).

2. Circuit arrangement according to Claim 1 characterised in that the potential to which the source of each switching transistor (ST) is connected is equal to the reference potential (ground) of the entire circuit arrangement.

3. Circuit arrangement according to Claim 1, characterised in that the potential to which the source of each switching transistor (ST) is connected is equal to the supply potential (VDD) of the entire circuit arrangement.

4. Circuit arrangement according to one of the preceding claims characterised in that the precharging device (PC) has a RS flip-flop circuit (FF) with two mutually complementary outputs (Q, $\overline{Q}$), and in that the outputs (Q, $\overline{Q}$) are connected via further switching transistors (WST) to the pair of fault lines (FLA, FLB).

5. Circuit arrangement according to one of the preceding claims, characterised in that the comparator circuit (VGL) is an XOR circuit.

6. Circuit arrangement according to one of Claims 1 to 4, characterised in that the comparator circuit (VGL) is an XNOR circuit.

7. Method for testing memory cells which are arranged in a matrix and can be driven via word lines and bit lines, the bit lines of which are divided into two identical halves by an evaluation circuit in each case, characterised by the following features:
   - in the test case, all memory cells (SZ) connected to a word line (WL) are charged to an equal logic level,
   - a pair of fault lines (FLA, FLB) is charged to two mutually complementary logic levels, the signifiance of which is equal to those logic levels which can be written into the memory cells (SZ) in the form of electric charges,
   - a word line (WL) is activated so that the charge stored in the memory cells connected to it reaches the respective associated bit line halves (BL, $\overline{BL}$),
   - the evaluator circuits (BWS) evaluate and amplify the charges read out in this way and thus form the logic levels associated with the read-out charges,
   - the logic levels drive switching means (ST) which switch-through or block depending on how they are driven,
   - depending on the switching behaviour of the switching means, the two fault lines (FLA, FLB) retain their logic state or one of the fault lines (FLA; FLB) changes it,

   - it is checked by means of a comparator circuit (VGL) whether the fault lines still have the mutually complementary logic levels applied as a result of the precharging after the charges of the memory cells (SZ) have been read out and evaluated.

8. Method according to Claim 7, characterised in that the precharging is carried out using a RS flip-flop (FF), and in that the outputs (Q, $\overline{Q}$) of the RS flip-flop (FF) are disconnected from the fault lines (FLA, FLB) by further switching means (WST) after the precharging.

9. Method according to Claim 7 or Claim 8, characterised in that the evaluation is carried out by the comparator circuit (VGL) by means of an XOR circuit.

10. Method according to Claim 7 or Claim 8, characterised in that the evaluation is carried out by the comparator circuit (VGL) by means of an XNOR circuit.

11. Method according to one of Claims 7 to 10, characterised in that logic levels are assigned to the two lines of the pair of fault lines (FLA, FLB) in such a way that, for the fault line (FLA; FLB) which is connected via switching means (ST) connected to it to the memory cells (SZ) to be tested in a test cycle, the logic level is complementary to the logic level which the memory cells (SZ) to be tested have in the form of a stored charge in the 'no fault' case.

12. Method according to one of Claims 7 to 10, characterised in that the logic levels are assigned to the two lines of the pair of fault lines (FLA, FLB) in such a way that, for the fault line (FLA; FLB) which is connected via switching means (ST) connected to it to the memory cells (SZ) to be tested in a test case, the logic level is equal to the logic level which the memory cells (SZ) to be tested have in the form of a stored charge in the 'no fault' case.

**Revendications**

1. Montage pour tester des cellules de mémoire disposées suivant une matrice et qui peuvent être commandées par l'intermédiaire de lignes de transmission de mots et de lignes de transmission de bits, et dans lequel à chaque ligne de transmission de bits est associé un circuit d'évaluation qui subdivise la ligne de transmission de bits en deux moitiés identiques, caractérisé par les caractéristiques suivantes :
- un couple de lignes (FLA,FLB) de signalisation de défauts est raccordé à un dispositif de précharge (PC),
- le couple de lignes (FLA,FLB) de signalisation de défauts forme des entrées d'un circuit comparateur (VGL),
- un signal de sortie (X) du circuit comparateur (VGL) indique, lors du test, l'apparition de défauts,
- chaque moitié (BL,$\overline{\text{BL}}$) de chaque ligne de transmission de bits est raccordée à la grille d'un transistor de commutation (ST),
- la source de chacun des transistors de commutation (ST) est raccordée à un potentiel qui correspond à l'un de deux niveaux logiques complémentaires l'un de l'autre, que prend le couple de lignes (FLA,FLB) de signalisation de défauts, lors du test,
- pour chaque ligne de transmission de bits, d'une part le drain du transistor de commutation (ST), dont la grille est raccordée à la seconde moitié ($\overline{\text{BL}}$) de la ligne de transmission de bits, est raccordé à la première ligne (FLA) de signalisation de défauts du couple de lignes (FLA, FLB) de signalisation de défauts, et d'autre part le drain du transistor de commutation (ST), dont la grille est raccordée à la première moitié (BL) de la ligne de transmission de bits, est raccordée à la seconde ligne (FLB) de signalisation de défauts du couple de lignes (FLA, FLB) de signalisation de défauts.

2. Montage suivant la revendication 1, caractérisé par le fait que le potentiel, auquel est placée la source de chaque transistor de commutation (ST), est égale au potentiel de référence (masse) de l'ensemble du montage.

3. Montage suivant la revendication 1, caractérisé par le fait que le potentiel, auquel est placée la source de chaque transistor de commutation (ST), est égal au potentiel d'alimentation (VDD) de l'ensemble du montage.

4. Montage suivant l'une des revendications précédentes, caractérisé par le fait que le dispositif de précharge (PC) comporte un circuit à bascule bistable de type RS (FF) comportant deux sorties (Q,$\overline{\text{Q}}$) complémentaires l'une de l'autre et que les sorties (Q,$\overline{\text{Q}}$) sont raccordées, par l'intermédiaire d'autres transistors de commutation (WST), au couple de lignes (FLA,FLB) de signalisation de défauts.

5. Montage suivant l'une des revendications précédentes, caractérisé par le fait que le circuit comparateur (VGL) est un circuit OU-Exclusif.

6. Montage suivant l'une des revendications 1 à 4, caractérisé par le fait que le comparateur (VGL) est un circuits NON-OU-Exclusif.

7. Procédé pour tester des cellules de mémoire disposées suivant une matrice et qui peuvent être commandées par l'intermédiaire de lignes de transmission de mots et de lignes de transmission de bits, et dans lequel à chaque ligne de transmission de bits est associé un circuit d'évaluation qui subdivise la ligne de transmission de bits en deux moitiés identiques, caractérisé par les caractéristiques suivantes :
- lors du test, toutes les cellules de mémoire (SZ) raccordées à une ligne de transmission de mots (WL) sont chargées à un même potentiel logique,
- un couple de lignes (FLA,FLB) de signalisation de défauts est chargé à deux niveaux logiques complémentaires l'un de l'autre, dont les valeurs sont identiques à celles des niveaux logiques qui peuvent être enregistrés dans les cellules de mémoire (SZ) sous la forme de charges électriques,
- une ligne de transmission de mots (WL) est activée de telle sorte que la charge stockée dans les cellules de mémoire, qui sont raccordées à cette ligne, parvient aux moitiés respectivement associées (BL,$\overline{\text{BL}}$) de la ligne de transmission de bits,
- les circuits d'évaluation (BWS) évaluent et amplifient les charges ainsi lues et forment ainsi les niveaux logiques associés aux charges lues,
- les niveaux logiques commandent des moyens de commutation (ST), qui, en fonction de leur commande, passent à l'état conducteur ou bloqué,
- en fonction du comportement de commutation des moyens de commutation, les deux lignes (FLA,FLB) de signalisation de défauts conservent leur état logique où l'une des lignes (FLA; FLB) de signalisation de défauts modifie cet état logique,
- un circuit comparateur (VGL) vérifie si, après la lecture et l'évaluation des charges des cellules de mémoire (SZ), les lignes de signalisation de défauts possèdent encore les niveaux logiques complémentaires l'un de l'autre, qui sont appliqués au moyen de la précharge.

8. Procédé suivant la revendication 7, caractérisé par le fait que la précharge est réalisée moyennant l'utilisation d'une bascule bistable de type RS (FF), et que les sorties $(Q,\overline{Q})$ de la bascule bistable de type RS (FF) sont déconnectées des lignes (FLA,FLB) de signalisation de défauts, par d'autres moyens de commutation (WST), après la précharge.

9. Procédé suivant la revendication 7 ou 8, caractérisé par le fait que l'évaluation est réalisée par le circuit comparateur (VGL) à l'aide d'un circuit OU-Exclusif.

10. Procédé suivant la revendication 7 ou 8, caractérisé par le fait que l'évaluation est exécutée par le circuit comparateur (VGL) à l'aide d'un circuit NON-OU-Exclusif.

11. Procédé suivant l'une des revendications 7 à 10, caractérisé par le fait que l'association des niveaux logiques aux deux lignes du couple de lignes (FLA,FLB) de signalisation de défauts est agencée de telle sorte que pour la ligne (FLA;FLB) de signalisation de défauts, qui est raccordée par l'intermédiaire de moyens de commutation (ST), qui lui sont raccordés, aux cellules de mémoire (SZ) devant être testées au cours d'un cycle de test, le niveau logique est complémentaire du niveau logique que les cellules (SZ) à tester possèdent sous la forme d'une charge stockée, dans le cas "bon".

12. Procédé suivant l'une des revendications 7 à 10, caractérisé par le fait que l'association des niveaux logiques aux deux lignes du couple de lignes (FL1,FLB) de signalisation de défauts est telle que pour la ligne (FLA; FLB) de signalisation de défauts, qui est raccordée par l'intermédiaire de moyens de commutation (ST), qui lui sont raccordés, aux cellules de mémoire (SZ) devant être testées lors d'un test, le niveau logique est égal au niveau logique que les cellules de mémoire (SZ) devant être testées possèdent sous la forme d'une charge stockée, dans le cas "bon".

EP 0 286 852 B1

10